# EUROPEAN PATENT SPECIFICATION

(11) **EP 2 975 661 B1**
(45) Date of publication and mention of the grant of the patent: **19.09.2018**
(21) Application number: 15001719.2
(22) Date of filing: 10.06.2015
(51) Int. Cl.: H01L 39/24

(54) **PRECURSOR FOR PRODUCING NB3SN SUPERCONDUCTING WIRES**
VORLÄUFERSUBSTANZ ZUR HERSTELLUNG VON NB3SN-SUPRALEITERDRÄHTEN
PRÉCURSEUR POUR LA PRODUCTION DE FILS SUPRACONDUCTEURS EN NB3SN

(30) Priority: 18.07.2014 JP 2014148076
(43) Date of publication of application: 20.01.2016
(73) Proprietor: Japan Superconductor Technology, Inc., Kobe-shi Hyogo 651-2271 (JP)
(72) Inventor: Takashi, Hase, Kitakyushu-shi, Fukuoka, 800-0007 (JP); Yukinobu, Murakami, Kitakyushu-shi, Fukuoka, 800-0007 (JP)
(74) Representative: Müller-Boré & Partner Patentanwälte PartG mbB

(56) References cited:
- EP-A1- 1 638 151
- EP-A1- 2 752 856
- DE-A1- 19 612 274
- JP-A- H06 325 643
- US-A1- 2002 194 724

## Description

The present invention relates to a precursor for producing Nb₃Sn superconducting wires.

Japanese Unexamined Patent Application Publication No. 6-325643 and No. 2007-141682 describe a precursor for producing Nb₃Sn superconducting wires. Figs. 1 and 2 of Japanese Unexamined Patent Application Publication No. 2007-141682 illustrate a precursor that includes a plurality of primary assemblies (a primary stack (5)) in a secondary assembly (a secondary multifilament billet (7)). Each of the primary assemblies (5) includes a plurality of Nb filaments (Nb or Nb alloy filaments (1)) in a bronze region (a bronze matrix (2)).

The paragraphs [0008] and [0009] of Japanese Unexamined Patent Application Publication No. 2007-141682 describe "A higher Sn concentration of the bronze matrix results in a higher critical current density Jc in a high magnetic field and is therefore advantageous to the development of a superconducting magnet that can produce a higher magnetic field. However, the Sn solubility limit of an α phase of a Cu-Sn base alloy is 15.8% by mass, and a Sn content above the Sn solubility limit results in formation of a Cu-Sn intermetallic compound (typically a "δ phase").... In an actual bronze ingot production step, the solubility limit is approximately 15.6% by mass in terms of cooling. The δ phase is harder and less ductile than the α phase and is therefore responsible for wire cracking in reduction processing."

The paragraph [0021] of Japanese Unexamined Patent Application Publication No. 2007-141682 describes "It was found that the addition of a third element Ti and/or Zr to a Cu-Sn base alloy can eliminate a δ phase from the Cu-Sn base alloy. Thus, the δ phase is not formed by adding Sn to a Cu-Sn base alloy in an amount that exceeds the conventional solubility limit of 15.6% by mass at normal temperature."

The same paragraph describes "More than 15.6% by mass Sn is partially undissolved in the α phase. Undissolved Sn precipitates as Cu-Sn-Ti or Cu-Sn-Zr. When the concentration of a third element (Ti and/or Zr) is appropriate, however, these precipitates are as small as approximately 2 µm or less and are smaller than Nb filaments. Thus, these precipitates do not affect the processability of the wire."

However, when the concentration of Sn in a bronze region (a Cu-Sn base alloy) is as high as 15% or more by weight, the number density of Cu-Sn-Ti or Cu-Sn-Zr precipitates in the bronze region is higher (than when the concentration of Sn is less than 15% by weight). Thus, precipitates, such as Cu-Sn-Ti, affect processing of Nb filaments having a good shape, and the Nb filaments may be deformed (details are described later). Nb₃Sn superconducting wires that include Nb filaments processed in a bad shape have a lower critical current density than Nb₃Sn superconducting wires that include Nb filaments processed in a good shape.

A standard bronze process is shown, for example, in DE 196 12 274 A1, EP 1 6 38 151 A1 shows a double-bronze process suitable for higher Sn concentrations. Accordingly, it is an object of the present invention to allow Nb filaments to be processed in a good shape and thereby provide a precursor for producing Nb₃Sn superconducting wires that have an improved critical current density and a high n value.

A precursor for producing Nb₃Sn superconducting wires according to a first invention includes a plurality of primary assemblies. Each of the primary assemblies includes a bronze region having a Sn concentration of 15% or more by weight and containing at least one additive of Ti and Zr in an amount of 0.3% to 0.5% by weight, and a plurality of Nb filaments embedded in the bronze region. The primary assemblies satisfy 0.10 ≤ ds/df ≤ 0.35 wherein ds denotes a space between adjacent Nb filaments aligned in a direction toward a central portion of a cross section of each of the primary assemblies viewed in an axial direction of the corresponding primary assembly, and df denotes the diameter of the Nb filaments.

A precursor for producing Nb₃Sn superconducting wires according to a second invention includes a plurality of primary assemblies. Each of the primary assemblies includes a bronze region having a Sn concentration of 15% or more by weight and containing at least one additive of Ti and Zr in an amount of 0.3% to 0.5% by weight, and a plurality of Nb filaments embedded in the bronze region. The primary assemblies satisfy 2.1 ≤ L/df ≤ 3.1, wherein L denotes a space between a Nb filament of one of the primary assemblies and the nearest Nb filament of adjacent one of the primary assemblies in a cross section of the primary assemblies viewed in an axial direction of the corresponding primary assemblies, and df denotes the diameter of the Nb filaments.

A precursor for producing Nb₃Sn superconducting wires according to a third invention has a circular cross section and includes a plurality of primary assemblies. Each of the primary assemblies includes a bronze region having a Sn concentration of 15% or more by weight and containing at least one additive of Ti and Zr in an amount of 0.3% to 0.5% by weight, and a plurality of Nb filaments embedded in the bronze region. The primary assemblies satisfy 0.08 ≤ ds/df ≤ 0.40 wherein ds denotes a space between adjacent Nb filaments aligned in a direction toward a central portion of a cross section of each of the primary assemblies viewed in an axial direction of the corresponding primary assembly, and df denotes the diameter of the Nb filaments.

A precursor for producing Nb₃Sn superconducting wires according to a fourth invention has a circular cross section and includes a plurality of primary assemblies. Each of the primary assemblies includes a bronze region having a Sn concentration of 15% or more by weight and containing at least one additive of Ti and Zr in an amount of 0.3% to 0.5% by weight, and a plurality of Nb filaments embedded in the bronze region. The primary assemblies satisfy 1.9 ≤ L/df ≤ 3.2, wherein L denotes a space between a Nb filament of one of the primary assemblies and the nearest Nb filament of adjacent one of the primary assemblies in a cross section of the primary assemblies viewed in an axial direction of the corresponding primary assemblies, and df denotes the diameter of the Nb filaments.

In accordance with the first to fourth inventions, an improved critical current density and a high n value can be achieved by allowing Nb filaments to be processed in a good shape.
Fig. 1 is a cross-sectional view of a precursor 1 (a precursor for producing Nb₃Sn superconducting wires) viewed in the axial direction of the precursor 1.
Fig. 2 is a cross-sectional view of adjacent primary assemblies 10 (see Fig. 1) viewed in the axial direction of the corresponding primary assemblies.
Fig. 3 is a cross-sectional view of a primary multifilament 110 for producing the primary assemblies 10 illustrated in Fig. 2 viewed in the axial direction of the primary multifilament 110.
Fig. 4 is a graph showing the relationship between the ratio ds/df of the space ds to the diameter df illustrated in Fig. 2 and the critical current density (nonCu-Jc).
Fig. 5 is a graph showing the relationship between the space L illustrated in Fig. 2 and the critical current density (nonCu-Jc).
Fig. 6 is a cross-sectional view of a precursor 201 according to a second embodiment, which corresponds to Fig. 1.
Fig. 7 is a graph of the second embodiment, which corresponds to Fig. 4.
Fig. 8 is a graph of the second embodiment, which corresponds to Fig. 5.
Fig. 9 is a cross-sectional view of a primary assembly 310 of a known precursor viewed in the axial direction of the primary assembly 310.
Fig. 10 is a cross-sectional view of a Cu-Sn-Ti compound 313 between adjacent Nb filaments 312.

### First Embodiment

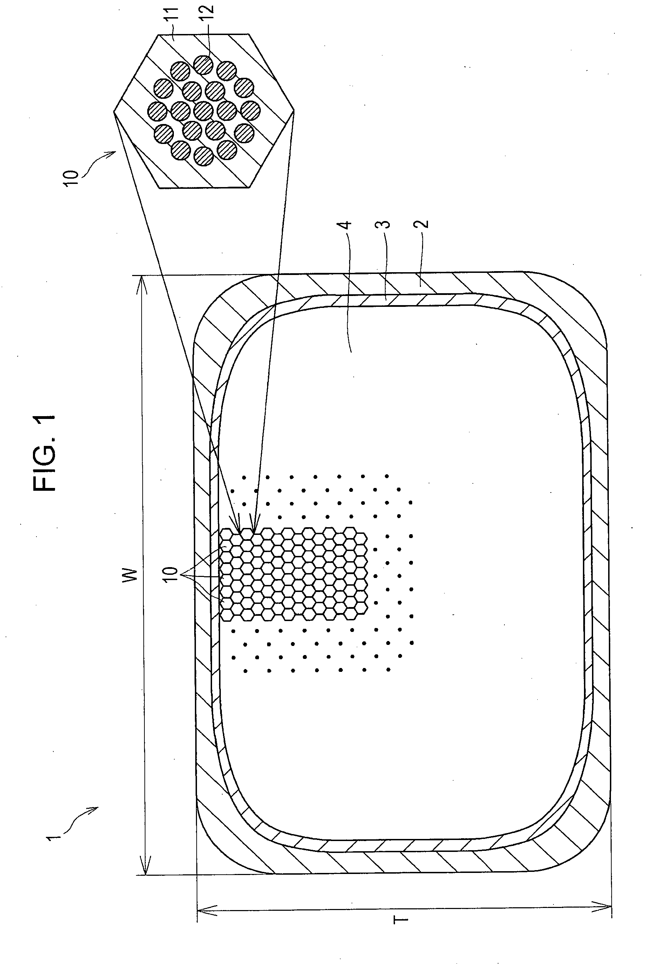

A precursor 1 (a precursor for producing Nb₃Sn superconducting wires) according to a first embodiment illustrated in Fig. 1 will be described below with reference to Figs. 1 to 5.

The precursor 1 (a precursor for a high Sn concentration bronze processed Nb₃Sn superconducting wire) is used to produce a Nb₃Sn superconducting wire (hereinafter referred to simply as a "superconducting wire") by a bronze process. A superconducting wire is produced by subjecting the precursor 1 to Nb₃Sn forming heat treatment to form a Nb₃Sn superconducting phase (Nb₃Sn phase). This superconducting wire can be used as a superconducting magnet coil. This superconducting magnet can be used in nuclear magnetic resonance (NMR) analyzers, physical property evaluation apparatuses, power storage systems, and nuclear fusion reactors. The precursor 1 is a secondary multifilament subjected to wire drawing or reducing diameter processing. Details are described later.

A superconducting coil is produced from the precursor 1 such that the gaps (dead spaces) between winding wires are reduced. More specifically, the precursor 1 has a rectangular cross section. The precursor 1 is a flat wire, for example. More specifically, the precursor 1 has a rectangular (including generally rectangular) cross section viewed in the axial direction thereof. The term "cross section", as used hereinafter, refers to a cross section viewed in the axial direction of the precursor 1 (in the axial direction of a primary assembly 10 described below). The term "rectangular" includes rectangular with four round corners. The dead spaces are decreased as the angles of the four corners of the rectangle approach right angles. The presence of a straight line between two adjacent corners (two corners except the opposite corner) of a rectangle is a prerequisite for "rectangular". More specifically, the presence of two parallel straight lines and two parallel straight lines perpendicular thereto on the periphery of a cross section of the precursor 1 is a prerequisite for "rectangular". The "parallel" and "perpendicular" may be "substantially parallel" and "substantially perpendicular". The aspect ratio W/T of the precursor 1 is 2.30 or less (details are described later), wherein W denotes the width (long side length) of a cross section of the precursor 1, and T denotes the thickness (short side length) of the cross section. A superconducting wire produced from the precursor 1 has the same (including substantially the same) cross-sectional structure as the precursor 1. The precursor 1 includes a stabilized copper layer 2, a diffusion barrier layer 3, and a superconducting matrix 4.

The stabilized copper layer 2 prevents burn damage to the Nb₃Sn phase. More specifically, when the state of a superconducting wire changes from the superconducting state to the normal conducting state, the Nb₃Sn phase may be damaged by burning due to an excess current. The stabilized copper layer 2 prevents the burn damage. The stabilized copper layer 2 is disposed on the outermost periphery of the precursor 1. The shape of the periphery of a cross section of the stabilized copper layer 2 corresponds to the cross-sectional shape of the precursor 1.

The diffusion barrier layer 3 prevents the diffusion of Sn from the superconducting matrix 4 to the outside (the stabilized copper layer 2) during the Nb₃Sn forming heat treatment. The diffusion barrier layer 3 is disposed inside the stabilized copper layer 2 and outside the superconducting matrix 4.

The Nb₃Sn phase is formed in the superconducting matrix 4 by the Nb₃Sn forming heat treatment. The superconducting matrix 4 includes a plurality of (many) primary assemblies 10. Fig. 1 illustrates part of the plurality of primary assemblies 10. Some of the illustrated primary assemblies 10 are denoted by the reference numeral.

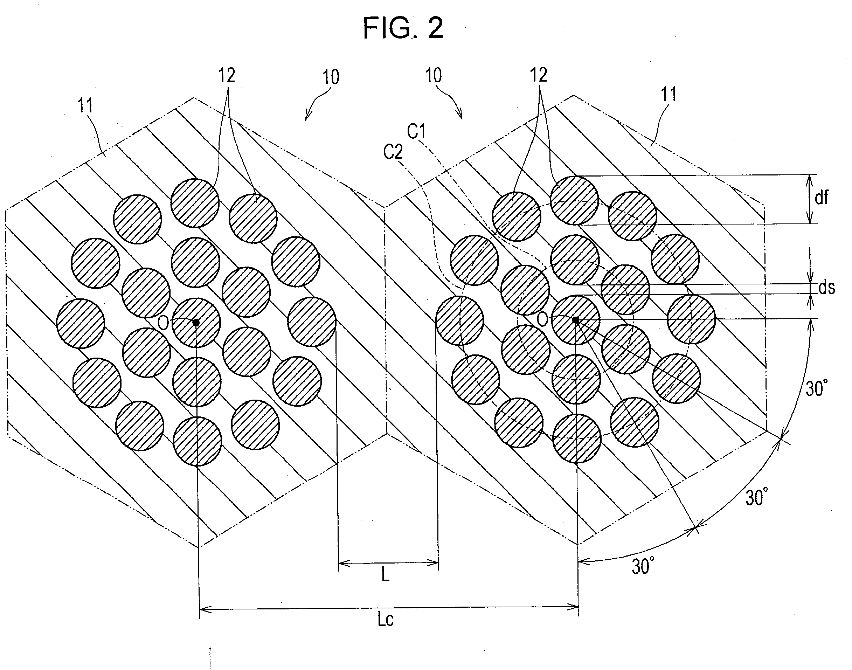

Each of the primary assemblies 10 includes a bronze region 11 (described below) and a plurality of (many) Nb filaments 12 (described below). The number of primary assemblies 10 constituting the superconducting matrix 4 may be tens, one hundred and tens, hundreds, one thousand and hundreds, or thousands. The primary assemblies 10 are densely packed (in contact with each other). Each of the primary assemblies 10 may have a hexagonal (or circular) cross section. A center O represents the centroid (center of figure) of a cross section of each of the primary assemblies 10. The boundaries between the primary assemblies 10 are invisible after processing (after a secondary multifilament processing step described below). The boundaries are illustrated in Fig. 1. The boundaries are illustrated as imaginary lines (dash-dot-dot lines) in Fig. 2. As illustrated in Fig. 1, each of the primary assemblies 10 includes the bronze region 11 and the Nb filaments 12.

The bronze region 11 contains a Cu-Sn base alloy. The material of the bronze region 11 is composed predominantly of a Cu-Sn base alloy. The bronze region 11 is composed predominantly of a solid solution in which Sn is dissolved in Cu (an α phase). The bronze region 11 has a Sn concentration of 15% or more by weight. The bronze region 11 contains an additive element (Ti and/or Zr), which may constitute approximately 0.3% to 0.5% by weight. The bronze region 11 may contain a minute amount of (for example, less than 0.5% by weight) impurities.

The Nb filaments 12 (Nb filaments) contain pure Nb or a Nb base alloy. The material of the Nb filaments 12 is composed entirely or predominantly of pure Nb or a Nb base alloy. The Nb filaments 12 may contain a minute amount of (for example, less than 0.5% by weight) impurities. The Nb filaments 12 may contain an additive element (for example, Ta, Hf, Zr, and/or Ti), which constitutes approximately 0.5% to 10% by weight. The Nb filaments 12 are embedded in the bronze region 11. The number of Nb filaments 12 in each of the primary assemblies 10 may be 19 (or 18 or less or 20 or more). In Figs. 1 and 2, some of the Nb filaments 12 are denoted by the reference numeral. For example, the Nb filaments 12 have a circular cross section (details are described later).

The Nb filaments 12 are arranged as described below. As illustrated in Fig. 2, the Nb filaments 12 are arranged in circles (or generally circles) in a cross section of each of the primary assemblies 10. The centroid of the Nb filaments 12 in each of the primary assemblies 10 (substantially) coincides with the center O of the corresponding cross section of the primary assemblies 10. The Nb filaments 12 are arranged near a central portion of a cross section of each of the primary assemblies 10. A specific example of the arrangement of the Nb filaments 12 in a cross section of each of the primary assemblies 10 is described below. One of the Nb filaments 12 is disposed at the center O in a cross section of each of the primary assemblies 10. The others of the Nb filaments 12 are arranged in circles (a circle C1 and a circle C2). The centers of the circle C1 and the circle C2 (substantially) coincide with the center O. The number of the "circles" (the circle C1 and the circle C2) is two (may be one or three or more) in each of the primary assemblies 10. Six of the Nb filaments 12 are arranged on the inner circle C1 at angular intervals of 60 degrees. Twelve of the Nb filaments 12 are arranged on the outer circle C2 at angular intervals of 30 degrees. The dimensions of the Nb filaments 12 in a cross section of each of the primary assemblies 10 viewed in the axial direction of the Nb filaments 12 include a diameter df, a space ds, a space L, and a center-to-center distance Lc.

The diameter df is the diameter of the Nb filaments 12. The diameter df is the average value. More specifically, the diameter df is the average of the diameters of a plurality of (preferably 10 or more) Nb filaments 12. When the precursor 1 has a rectangular cross section, the diameter df in Fig. 2 is the diameter of the Nb filaments 12 on the periphery (the outermost periphery or the vicinity thereof) of a cross section of the precursor 1. The reason for this is described below. As illustrated in Fig. 1, when the precursor 1 has a rectangular cross section, the primary assemblies 10 on the periphery of a cross section of the precursor 1 have the cross-sectional structure as illustrated in Fig. 2. However, the primary assemblies 10 in a central portion of a cross section of the precursor 1 have a cross-sectional structure that looks as if the cross-sectional structure illustrated in Fig. 2 has been flattened. More specifically, the Nb filaments 12 in a central portion of a cross section of the precursor 1 (see Fig. 1) have a generally elliptical cross section. Thus, the diameter df is the diameter of the Nb filaments 12 on the periphery of a cross section of the precursor 1 (see Fig. 1).

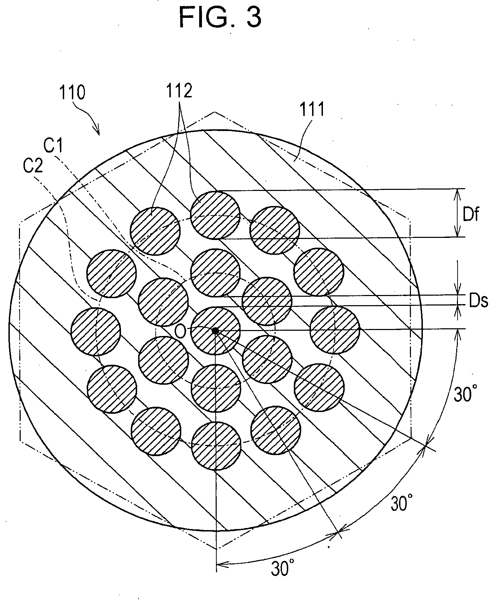

The space ds is the space between adjacent Nb filaments 12 in each of the primary assemblies 10 and is the space between adjacent Nb filaments 12 aligned in a direction toward a central portion of a cross section of each of the primary assemblies 10. The space ds is the average value. More specifically, the space ds is the average of the spaces between a plurality of (preferably 10 or more) pairs of adjacent Nb filaments 12. The "direction toward a central portion of a cross section of each of the primary assemblies 10" (hereinafter referred to as a "direction α") is the direction from the periphery of the cross section of each of the primary assemblies 10 to the center O (or the vicinity of the center O) of the cross section of each of the primary assemblies 10. When each of the primary assemblies 10 has a circular cross section (see Fig. 3), the "direction α" is the radial direction in a cross section of each of the primary assemblies 10. The space between Nb filaments 12 in directions other than the "direction α" is greater than or equal to the space ds. For example, the space between Nb filaments 12 on the circle C1 or the circle C2 (in the circumferential direction) is greater than or equal to the space ds and may be (substantially) equal to the space ds. The space ds is equal to "the radius of the circle C1 - the diameter df'. The space ds is also equal to "the radius of the circle C2 - the radius of the circle C1 - the diameter df'.

The space L is a space between two nearest Nb filaments 12 each selected from adjacent primary assemblies 10. Like the diameter df, the space L is the average value. When the precursor 1 (see Fig. 1) has a rectangular cross section, like the diameter df, the space L is the space between Nb filaments 12 on the periphery of a cross section of the precursor 1.

The center-to-center distance Lc is the distance between the centers O of adjacent primary assemblies 10. Like the diameter df, the center-to-center distance Lc is the average value. When the precursor 1 (see Fig. 1) has a rectangular cross section, like the diameter df, the center-to-center distance Lc is the distance between the centers O on the periphery of a cross section of the precursor 1.

### Production Method

A method for producing the precursor 1 illustrated in Fig. 1 includes a primary multifilament production step, a primary multifilament processing step, a secondary multifilament production step, and a secondary multifilament processing step.

The primary multifilament production step is a step of producing (fabricating) a primary multifilament 110 (a primary multifilament billet) illustrated in Fig. 3. The primary multifilament 110 corresponds to one of the primary assemblies 10 of the precursor 1 illustrated in Fig. 1. The components of the precursor 1 are hereinafter sometimes described in parentheses (the components of the precursor 1 are illustrated in Fig. 1). The primary multifilament 110 (primary assembly 10) illustrated in Fig. 3 is produced through the following [Step 1A] to [Step 1D]. The following dimensions are examples and may be changed. [Step 1A] A bronze region 111 (the bronze region 11) is prepared as an ingot. The bronze region 111 has a composition of Cu-15wt% Sn-0.3wt% Ti. The bronze region 111 has an outer diameter φ of 100 mm and a length of 350 mm. [Step 1B] Holes are bored at and around the center O of the bronze region 111. The number of the holes is 19. The space Ds (corresponding to the space ds in Fig. 2) between adjacent holes in the bronze region 111 aligned in the radial direction is 2.45 mm. The holes have a diameter of φ12 + 0.02 mm. [Step 1C] A Nb rod 112 (Nb filament 12) is inserted into the holes. The Nb rod 112 has a diameter Df (corresponding to the diameter df in Fig. 2) of φ12 mm. Thus, the ratio Ds/Df (corresponding to ds/df in Fig. 2) of the space Ds to the diameter Df is 0.20. [Step 1D] The bronze region 111 and the axial ends of the Nb rods 112 (the Nb filaments 12) after [Step 1C] are vacuum sealed by welding. The primary multifilament 110 (primary assembly 10) is formed through [Step 1A] to [Step 1D]. The cross-sectional structure of the primary multifilament 110 illustrated in Fig. 3 is the structure after [Step 1A] to [Step 1D]. The primary multifilament 110 has a bronze ratio of 2.5. The bronze ratio is calculated by dividing the cross-sectional area of the bronze region 111 (the bronze region 11) by the cross-sectional area of the Nb rods 112 (the Nb filaments 12). A plurality of the primary multifilaments 110 are produced.

In the primary multifilament processing step, the primary multifilament 110 (primary assembly 10) is processed. The primary multifilament 110 is processed through the following [Step 2A] and [Step 2B]. [Step 2A] The primary multifilament 110 is subjected to hot hydrostatic extrusion. The primary multifilament 110 is then repeatedly subjected to drawing and intermediate annealing. [Step 2B] The primary multifilament 110 subjected to [Step 2A] is processed with a hexagonal die so as to have a hexagonal cross section (see the dash-dot-dot line in Fig. 3). A hexagonal cross section of the primary multifilament 110 has a diagonal length in the range of approximately 2 to 3 mm.

In the secondary multifilament production step, a secondary multifilament (a secondary multifilament billet) (the precursor 1) is produced. The secondary multifilament (the precursor 1) is produced through the following [Step 3A] to [Step 3C]. [Step 3A] As illustrated in Fig. 1, 1470 primary multifilaments 110 (see Fig. 3) (the primary assemblies 10) subjected to [Step 2B] are bundled. The bundled primary multifilaments 110 (the primary assemblies 10) are wrapped in a Nb sheet (the diffusion barrier layer 3). [Step 3B] The primary multifilaments 110 (the primary assemblies 10) and the Nb sheet (the diffusion barrier layer 3) subjected to [Step 3A] are inserted into an oxygen-free copper pipe (the stabilized copper layer 2). [Step 3C] The axial ends of the oxygen-free copper pipe (the stabilized copper layer 2) subjected to [Step 3B] are vacuum sealed by welding. The secondary multifilament (corresponding to the precursor 1 subjected to [Step 4B] described below) is produced through [Step 3A] to [Step 3C].

In the secondary multifilament processing step, the secondary multifilament (the precursor 1) is processed. The secondary multifilament is processed through the following [Step 4A] and [Step 4B]. [Step 4A] The secondary multifilament (the precursor 1) subjected to [Step 3C] is subjected to hot hydrostatic extrusion. The secondary multifilament (the precursor 1) is then repeatedly subjected to drawing and intermediate annealing. [Step 4B] The secondary multifilament (the precursor 1) subjected to [Step 4A] is processed so as to have a rectangular cross section having a thickness T of 1.40 mm, a width W of 2.30 mm, an aspect ratio W/T of 1.64, and a cross-sectional area of 1.40 × 2.30 mm². The precursor 1 is produced through [Step 4B]. [Step 5] The precursor 1 is subjected to Nb₃Sn forming heat treatment in a vacuum at 720°C for 100 hours, thus producing a Nb₃Sn compound (a Nb₃Sn phase) between the bronze region 11 and the Nb filaments 12. Thus, a Nb₃Sn superconducting wire is produced. The precursor 1 is a precursor after [Step 4B] and before [Step 5].

### Examples of Dimensions

The precursor 1 produced through [Step 1A] to [Step 4B] has the following dimensions. The ratio ds/df of the space ds (1.2 µm) to the diameter df (6.0 µm) of the primary assemblies 10 illustrated in Fig. 2 is 0.20. The ratio Ds/Df of the space Ds (4.9 mm) to the diameter Df (φ12 mm) of the primary multifilament 110 illustrated in Fig. 3 is 0.20. The ds/df of the primary assemblies 10 illustrated in Fig. 2 is (substantially) equal to the Ds/Df of the primary multifilament 110 illustrated in Fig. 3. Thus, the ds/df of the primary assemblies 10 illustrated in Fig. 2 can be controlled by changing the Ds/Df of the primary multifilament 110. The ratio L/df of the space L (16.2 µm) to the diameter df (6.0 µm) of the primary assemblies 10 is 2.7. The L/df of the primary assemblies 10 illustrated in Fig. 2 can be controlled by changing the diameter of the bronze region 111, the diameter Df, and the space Ds of the primary multifilament 110 illustrated in Fig. 3. The center-to-center distance Lc of adjacent primary assemblies 10 is 51 µm.

### Processability of Nb Filaments 12

As described above, the Nb rods 112 (the Nb filaments 12) of the primary multifilament 110 (primary assembly 10) are subjected to wire drawing (hot hydrostatic extrusion or drawing). In addition to the primary assemblies 10 of the precursor 1 (see Fig. 1), assemblies under processing from the primary multifilaments 110 to the primary assemblies 10 are hereinafter also referred to as primary assemblies 10. Likewise, in addition to the Nb filaments 12 of the precursor 1 (see Fig. 1), Nb under processing from the Nb rods 112 to the Nb filaments 12 is hereinafter also referred to as a Nb filament 12. The Nb filaments 12 are preferably processed in a good shape (good processing). Superconducting wires that include the Nb filaments 12 not subjected to good processing have a lower critical current density than superconducting wires that include the Nb filaments 12 subjected to good processing. The Nb filaments 12 having a "good shape" have a circular (including substantially circular) cross section and a constant (including substantially constant) diameter df.

Good processing of the Nb filaments 12 is hampered by a substance that is harder than the Nb filaments 12. The processability of the Nb filaments 12 is described in detail below. As described in Description of the Related Art, a higher concentration of Sn in the bronze region 11 illustrated in Fig. 1 results in a higher critical current density of a superconducting wire produced from the precursor 1. However, a Sn concentration of more than approximately 15.8% by weight results in formation of a Cu-Sn compound (an intermetallic compound, typically a δ phase). The Cu-Sn compound is harder than Nb and has a size greater than the diameter df of the Nb filaments 12. The Cu-Sn compound after [Step 2B] may have a particle size in the range of 50 to 100 µm. The Cu-Sn compound affects good processing of the Nb filaments 12 (for example, makes good processing impossible).

The addition of approximately 0.3% to 0.5% by weight at least one additive of Ti and Zr to the bronze region 11 prevents (or reduces) the formation of a Cu-Sn compound. Thus, the Sn concentration can be higher than 15.8% by weight. The addition of the additive to the bronze region 11 results in formation of at least one of a Cu-Sn-Ti compound and a Cu-Sn-Zr compound (hereinafter referred to as a Cu-Sn-Ti compound). The Cu-Sn-Ti compound may be harder than Nb and smaller than Cu-Sn compounds and may have a size smaller than the diameter df of the Nb filaments 12. The Cu-Sn-Ti compound after [Step 4B] may have a particle size of 5 µm or less. Thus, even when the Cu-Sn-Ti compound is formed, the Nb filaments 12 may be subjected to good processing.

However, when the Sn concentration is 15% or more by weight (particularly more than 15.8% by weight), the Cu-Sn-Ti compound may affect good processing of the Nb filaments 12. The reason for this is described below. As described above, the primary assemblies 10 are repeatedly subjected to drawing and intermediate annealing (see [Step 2A]). This decreases the size of the Cu-Sn-Ti compound. Furthermore, the Sn concentration is higher on the periphery than in a central portion of a cross section of each of the primary assemblies 10, and the amount of Cu-Sn-Ti compound is higher on the periphery (a higher number density of the Cu-Sn-Ti compound). Thus, the Cu-Sn-Ti compound on the periphery may affect good processing of the Nb filaments 12. The Cu-Sn-Ti compound also exists in a central portion of a cross section of each of the primary assemblies 10. Thus, the Cu-Sn-Ti compound in the central portion may also affect good processing of the Nb filaments 12 (see Fig. 1), as described later.

### Experiments

Precursors having different ds/df and L/df (see Fig. 2) were prepared (the precursor 1 according to an embodiment and a precursor according to Comparative Example). The precursors were subjected to Nb₃Sn forming heat treatment [Step 5] to produce superconducting wires. The critical current density (nonCu-Jc) of each of the superconducting wires was measured in an external magnetic field of 20 tesla (T). The critical current density (nonCu-Jc) is calculated by dividing the critical current by the cross-sectional area of the precursor 1 excluding the stabilized copper layer 2. The precursors include a precursor according to "Comparative Example 1" and a precursor according to "Example 1".

### [Example 1] The precursor 1 according to Example 1 was produced through [Step 1A] to [Step 4B]. In "Example 1", ds/df was 0.20.

[Comparative Example 1] In Comparative Example 1, ds/df was 0.40. The precursor according to Comparative Example 1 was produced as described below. In [Step 1B], the space Ds in Fig. 3 was 4.9 mm instead of 2.45 mm, and Ds/Df was 0.40. The other steps were the same as [Step 1A] to [Step 4B]. In each precursor, the diameter df of the Nb filaments 12 was 6.0 µm, and the center-to-center distance Lc was 51 µm.

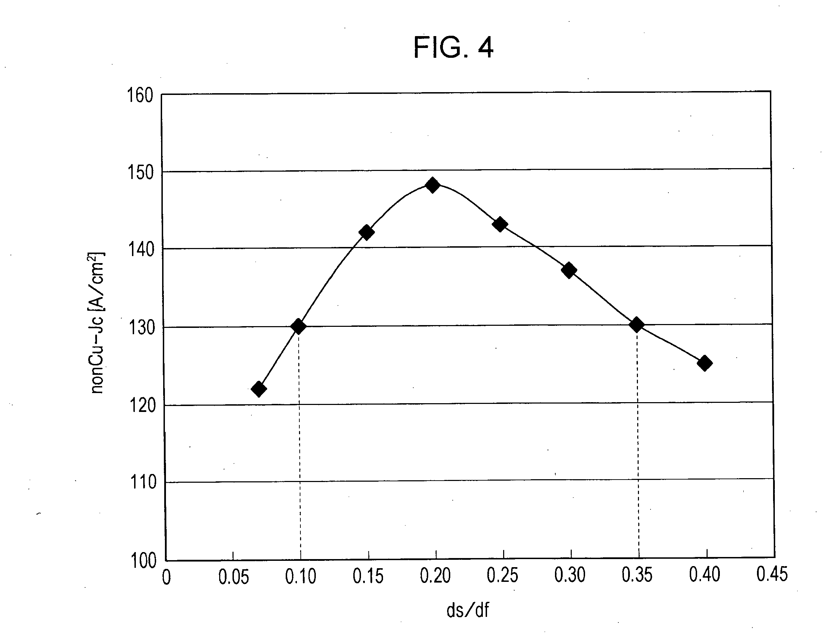

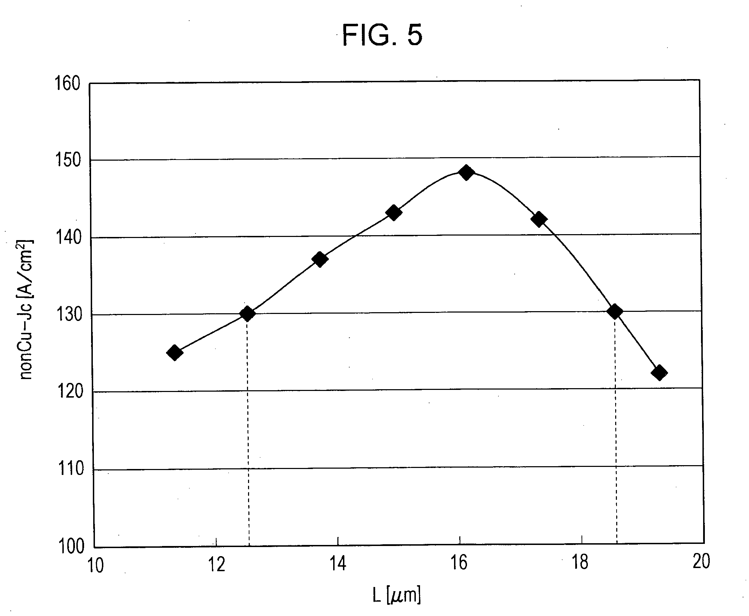

Figs. 4 and 5 show the results. Fig. 4 is a graph showing the relationship between ds/df (see Fig. 2) and the critical current density (nonCu-Jc). Fig. 5 is a graph showing the relationship between L (see Fig. 2) and the critical current density (nonCu-Jc).

[Results for Comparative Example 1] The results for Comparative Example 1 (ds/df = 0.40) are described below. As illustrated in Fig. 4, in Comparative Example 1, the critical current density was 125 A/mm². The critical current density in Comparative Example 1 was lower than 130 A/mm², which is a criterion for use of wires for high magnetic field NMR (hereinafter referred to as an "acceptance criterion"). In Comparative Example 1, the n value was 18, which is lower than the n value in Example 1 described below. The n value indicates the sharpness of transition from the superconducting state to the normal conducting state. A higher n value is preferred.

[Example 1] The results for Example 1 (ds/df = 0.20) are described below. In Example 1, the critical current density was 148 A/mm², which is higher than the acceptance criterion of 130 A/mm². In Example 1, the n value was 34, which is higher than the n value of Comparative Example 1.

### ds/df and ds

As illustrated in Fig. 4, within the range of 0.10 ≤ ds/df ≤ 0.35 (0.60 µm ≤ ds ≤ 2.10 µm), the critical current density was higher than or equal to the acceptance criterion of 130 A/mm², and the n value was as high as 30 to 34 (higher than the n value of Comparative Example 1). Within the range of 0.15 ≤ ds/df ≤ 0.25 (0.90 µm ≤ ds ≤ 1.50 µm), the critical current density was higher than or equal to 140 A/mm² ("preferred acceptance criterion").

### L and L/df

As illustrated in Fig. 5, within the range of 12.6 µm ≤ L ≤ 18.6 µm (2.1 ≤ L/df ≤ 3.1), the critical current density was higher than or equal to the acceptance criterion of 130 A/mm², and the n value was as high as 30 to 34 (higher than the n value of Comparative Example 1). Within the range of 15.0 µm ≤ L ≤ 17.4 µm (2.5 ≤ L/df ≤ 2.9), the critical current density was higher than or equal to the preferred acceptance criterion of 140 A/mm².

### Maximum Value of Space ds and Minimum Value of Space L

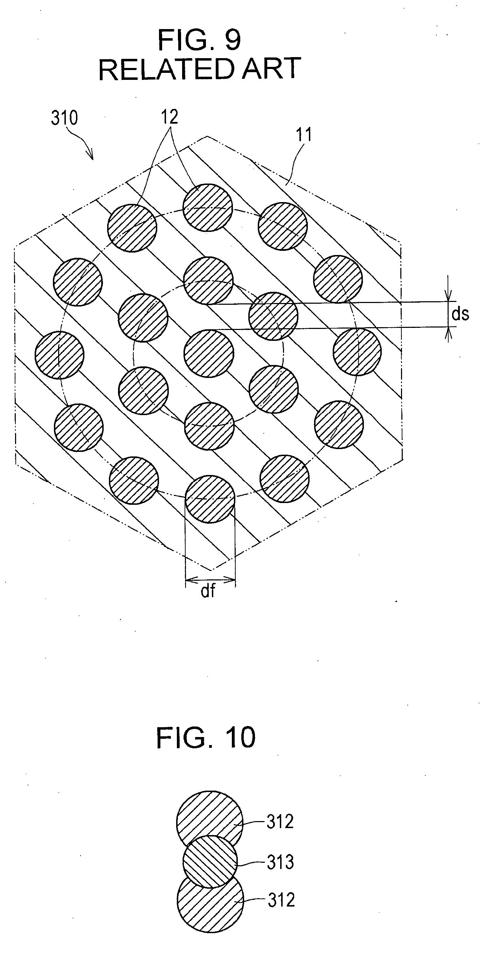

As the space ds increases or the space L decreases in Fig. 2, the Nb filaments 12 approach the periphery of a cross section of each of the primary assemblies 10 (see a primary assembly 310 in Fig. 9). A Cu-Sn-Ti compound on the periphery of a cross section of the primary assembly 310 (see Fig. 9) then affects good processing of the Nb filaments 12 and lowers the critical current density. More specifically, as illustrated in Figs. 4 and 5, in the case of ds/df > 0.35 or L/df < 2.1, the critical current density is lower than the acceptance criterion of 130 A/mm². On the other hand, as illustrated in Fig. 2, when the space ds and the space L of the Nb filaments 12 are appropriate, the Nb filaments 12 are arranged near a central portion of a cross section of each of the primary assemblies 10 rather than the periphery thereof. Thus, the Nb filaments 12 can be subjected to good processing without being affected by a Cu-Sn-Ti compound on the periphery of a cross section of each of the primary assemblies 10. This results in a high critical current density. More specifically, as illustrated in Figs. 4 and 5, in the case of ds/df ≤ 0.35 and/or L/df ≥ 2.1, the critical current density is equal to or higher than the acceptance criterion of 130 A/mm².

A narrower space ds between adjacent Nb filaments 12 illustrated in Fig. 2 results in a higher n value. The reason for this is described below. When an electric current flows through a first Nb filament 12 (Nb₃Sn phase) at a current density higher than the critical current density of the first Nb filament 12, the electric current moves to an adjacent second Nb filament 12 having a higher critical current density than the first Nb filament 12. A narrower space ds results in a narrower bronze region 11 between the adjacent Nb filaments 12 (which becomes a copper region after Nb₃Sn forming heat treatment) and a lower small resistance. This improves the n value. More specifically, the n value ranged from 30 to 34 in the case of ds/df ≤ 0.35 and/or L/df ≥ 2.1.

### Minimum Value of Space ds and Maximum Value of Space L

A Cu-Sn-Ti compound is also present in a central portion of a cross section of each of the primary assemblies 10 illustrated in Fig. 2. Thus, when the space ds is much smaller than the diameter df, or when the space L is much greater than the diameter df, a Cu-Sn-Ti compound (compound 313) may overlap with adjacent Nb filaments 312, as illustrated in Fig. 10. As a result, the Cu-Sn-Ti compound (compound 313) affects good processing of the Nb filaments 312. This results in a low critical current density. More specifically, as illustrated in Figs. 4 and 5, in the case of ds/df < 0.10 or L/df > 3.1, the critical current density is lower than the acceptance criterion of 130 A/mm². On the other hand, as illustrated in Fig. 2, when the space ds and the space L of the Nb filaments 12 are appropriate, a Cu-Sn-Ti compound in a central portion of a cross section of each of the primary assemblies 10 rarely overlaps with adjacent Nb filaments 12. Thus, the Nb filaments 12 are easily subjected to good processing, and the critical current density increases. More specifically, as illustrated in Figs. 4 and 5, in the case of ds/df ≤ 0.35 and/or L/df ≥ 2.1, the critical current density is equal to or higher than the acceptance criterion of 130 A/mm².

### Aspect Ratio

When the aspect ratio W/T illustrated in Fig. 1 is 2.30 or less, the experimental results are as described above. However, when the aspect ratio W/T is more than 2.30, the experimental results may be different from those described above. More specifically, when the aspect ratio W/T is more than 2.30, this results in narrow ds/df and L/df ranges in which the critical current density is higher than or equal to the acceptance criterion of 130 A/mm², or this results in a critical current density lower than the acceptance criterion. This is because in a central portion of a cross section of the precursor 1 having a rectangular cross section, the Nb filaments 12 have a flat (for example, elliptical) cross-section. The aspect ratio W/T is preferably 2.0 or less. When the aspect ratio W/T is 2.0 or less, the cross section of the Nb filaments 12 in a central portion of a cross section of the precursor 1 is closer to circular (as compared with the case of W/T > 2.0). The aspect ratio W/T is 1 or more.

### Advantage 1

The advantages of the precursor 1 illustrated in Fig. 1 will be described below. The precursor 1 has a rectangular cross section having an aspect ratio W/T of 2.30 or less. The precursor 1 includes the primary assemblies 10. Each of the primary assemblies 10 includes the bronze region 11 and the Nb filaments 12 embedded in the bronze region. The concentration of Sn in the bronze region 11 is 15% or more by weight.

[Structure 1] As illustrated in Fig. 2, the primary assemblies 10 satisfy 0.10 ≤ ds/df ≤ 0.35, wherein ds denotes a space between adjacent Nb filaments 12 aligned in a direction toward a central portion in a cross section of each of the primary assemblies 10 viewed in an axial direction of the corresponding primary assembly 10, and df denotes the diameter of the Nb filaments 12 (see Fig. 4).

### Advantage 1-1

In the [Structure 1], ds/df is 0.35 or less. The Nb filaments 12 are arranged closer to a central portion of a cross section of each of the primary assemblies 10 in the case of ds/df ≤ 0.35 than in the case of ds/df > 0.35. Thus, the Nb filaments 12 tend to be arranged at positions that are less affected by a Cu-Sn-Ti compound (or a Cu-Sn-Zr compound; the same applies hereinafter) formed in a large amount on the periphery of a cross section of each of the primary assemblies 10. Thus, the Nb filaments 12 can be processed in a good shape. As a result, a Nb₃Sn superconducting wire produced from the precursor 1 has a high critical current density.

### Advantage 1-2

In the [Structure 1], ds/df is 0.10 or more. The space ds between adjacent Nb filaments 12 is greater in the case of 0.10 ≤ ds/df than in the case of ds/df < 0.1. Thus, even when a Cu-Sn-Ti compound is present between adjacent Nb filaments 12, the Nb filaments 12 can be processed in a good shape. As a result, a Nb₃Sn superconducting wire produced from the precursor 1 has a high critical current density. Advantage 1-3

In the [Structure 1], ds/df is 0.35 or less, and therefore the space between adjacent Nb filaments 12 is narrower than the case of ds/df > 0.35. Thus, the n value is higher than the case of ds/df > 0.35. More specifically, only an increase in the space ds between adjacent Nb filaments 12 in order to achieve the "Advantage 1-2" may result in a low n value. However, the n value can be increased at ds/df ≤ 0.35.

### Advantage 2

[Structure 2] The primary assemblies 10 satisfy 2.1 ≤ L/df ≤ 3.1, wherein L denotes a space between a Nb filament 12 of one of the primary assemblies 10 and the nearest Nb filament 12 of adjacent one of the primary assemblies 10 in a cross section of the primary assemblies 10 viewed in an axial direction of the corresponding primary assemblies 10, and df denotes the diameter of the Nb filaments 12 (see Fig. 5).

### Advantage 2-1

In the [Structure 2], L/df is 2.1 or more. The Nb filaments 12 are more distant from the periphery of a cross section of each of the primary assemblies 10 in the case of 2.1 ≤ L/df than in the case of L/df < 2.1. Thus, the Nb filaments 12 are arranged at positions that are less affected by a Cu-Sn-Ti compound formed in a large amount on the periphery of a cross section of each of the primary assemblies 10. Thus, the Nb filaments 12 can be processed in a good shape. As a result, a Nb₃Sn superconducting wire produced from the precursor 1 has a high critical current density.

### Advantage 2-2

In the [Structure 2], L/df is 3.1 or less. The space ds between adjacent Nb filaments 12 tends to be greater in the case of L/df ≤ 3.1 than in the case of 3.1 < L/df. Thus, even when a Cu-Sn-Ti compound is present between adjacent Nb filaments 12, the Nb filaments 12 can be processed in a good shape. As a result, a Nb₃Sn superconducting wire produced from the precursor 1 has a high critical current density.

### Advantage 2-3

In the [Structure 2], L/df is 2.1 or more, and therefore the space between adjacent Nb filaments 12 tends to be narrower than the case of L/df < 2.1. A narrow space between adjacent Nb filaments 12 results in a high n value. More specifically, only a decrease in space L and an increase in diameter df in order to achieve the "Advantage 2-2" may result in a low n value. However, the n value can be increased at 2.1 ≤ L/df.

### Second Embodiment

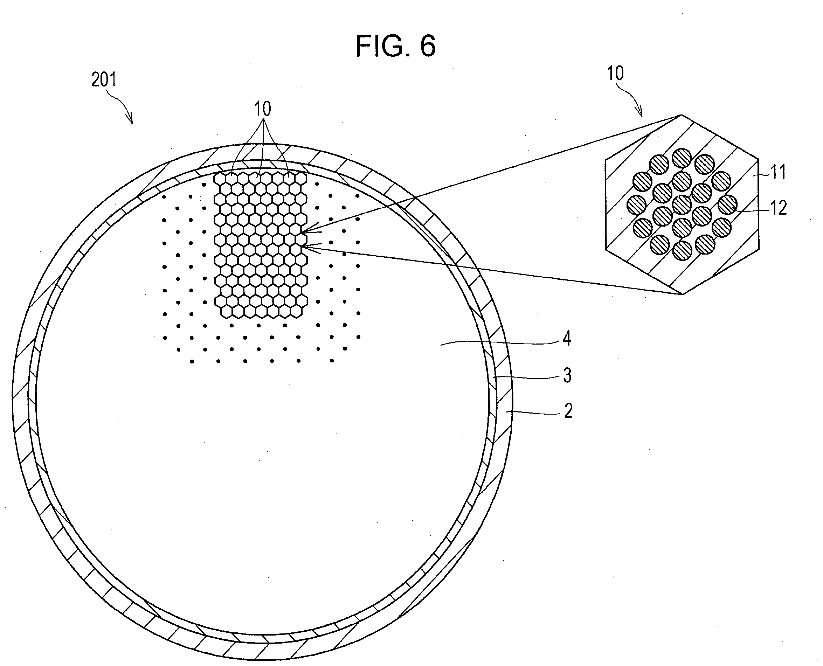

Differences between a precursor 201 (a precursor for producing Nb₃Sn superconducting wires) according to a second embodiment and the precursor 1 according to the first embodiment will be described below with reference to Fig. 6. Like components are denoted by like reference numerals throughout the figures and are not described again. Although the precursor 1 according to the first embodiment illustrated in Fig. 1 has a rectangular cross section, the precursor 201 according to the second embodiment illustrated in Fig. 6 has a circular cross section.

The precursor 201 has a circular cross section. The precursor 201 is a round wire. The term "circular" of the "circular cross section", as used herein, includes substantially circular (for example, substantially circular elliptical). In the first embodiment, the secondary multifilament (the precursor 1) is processed so as to have a rectangular cross section in [Step 4B]. In the second embodiment, instead of [Step 4B], the secondary multifilament (the precursor 201) is processed so as to have a circular cross section of φ = 1.62 mm (this step is referred to as [Step 4B']).

### Experiments

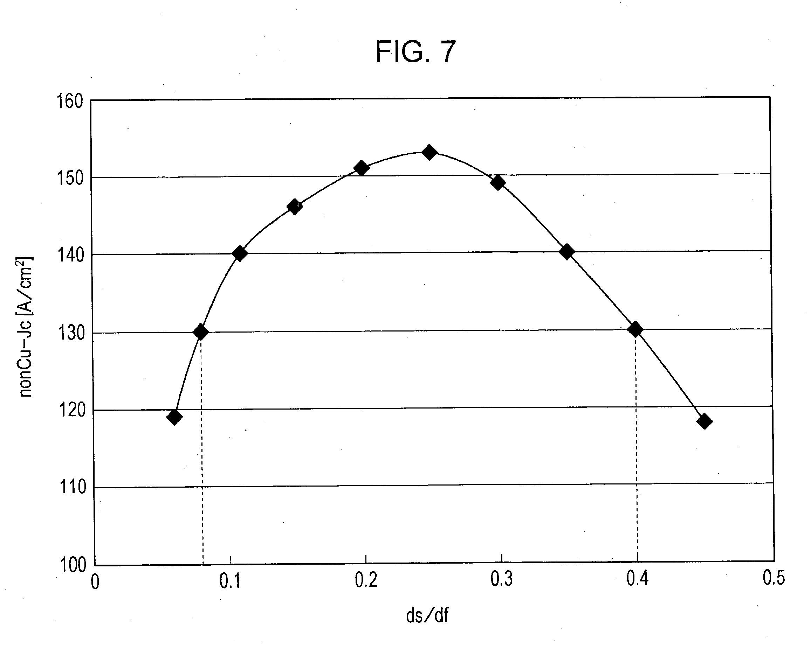

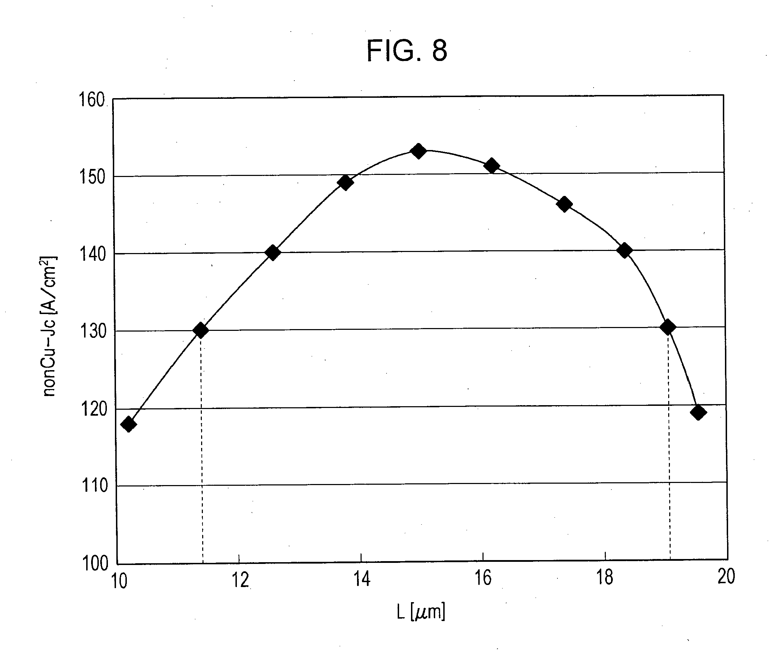

Precursors having different ds/df and L/df were prepared (the precursor 201 and a precursor having a circular cross section according to Comparative Example). The precursors were subjected to Nb₃Sn forming heat treatment [Step 5] to produce superconducting wires. The critical current density (nonCu-Jc) of each of the superconducting wires was measured in an external magnetic field of 20 T. Figs. 7 and 8 show the results. Fig. 7 is a graph showing the relationship between ds/df and the critical current density (nonCu-Jc). Fig. 8 is a graph showing the relationship between L/df and the critical current density (nonCu-Jc).

### ds/df and ds

As illustrated in Fig. 7, within the range of 0.08 ≤ ds/df ≤ 0.40 (0.48 µm ≤ ds ≤ 2.4 µm), the critical current density was higher than or equal to the acceptance criterion of 130 A/mm², and the n value was as high as 30 to 35 (higher than the n value of Comparative Example 1). Within the range of 0.11 ≤ ds/df ≤ 0.35 (0.66 µm ≤ ds ≤ 2.1 µm), the critical current density was higher than or equal to the preferred acceptance criterion of 140 A/mm².

### L and L/df

As illustrated in Fig. 8, within the range of 11.4 µm ≤ L ≤ 19.1 µm (1.9 ≤ L/df ≤ 3.2), the critical current density was higher than or equal to the acceptance criterion of 130 A/mm², and the n value was as high as 30 to 34. Within the range of 12.6 µm ≤ L ≤ 18.4 µm (2.1 ≤ L/df ≤ 3.1), the critical current density was higher than or equal to the preferred acceptance criterion of 140 A/mm².

In the second embodiment, the ranges of ds/df that satisfies the acceptance criterion, ds/df that satisfies the preferred acceptance criterion, L/df that satisfies the acceptance criterion, and L/df that satisfies the preferred acceptance criterion were broader than the ranges in the first embodiment. The reason for this is described below. As described above, in the precursor 1 having a rectangular cross section illustrated in Fig. 1, the Nb filaments 12 in a central portion of a cross section of the precursor 1 are flat (not shown). In the precursor 201 having a circular cross section illustrated in Fig. 6, the Nb filaments 12 in a central portion of a cross section of the precursor 201 are circular. Thus, the precursor 201 having a circular cross section has a higher critical current density than the precursor 1 having a rectangular cross section. For example, even when the precursor 1 and the precursor 201 are subjected to the same production steps before [Step 4B] or [Step 4B'], the precursor 201 has a higher critical current density than the precursor 1.

### Advantage 3

The advantages of the precursor 201 illustrated in Fig. 6 will be described below. The precursor 201 has a circular cross section.

[Structure 3] As illustrated in Fig. 2, the primary assemblies 10 satisfy 0.08 ≤ ds/df ≤ 0.40, wherein ds denotes a space between adjacent Nb filaments 12 aligned in a direction toward a central portion in a cross section of each of the primary assemblies 10 viewed in an axial direction of the corresponding primary assembly 10, and df denotes the diameter of the Nb filaments 12 (see Fig. 7).

Like the "Advantage 1-1" and "Advantage 1-2", the Nb filaments 12 of the [Structure 3] can be processed in a good shape. As a result, a Nb₃Sn superconducting wire produced from the precursor 201 having a circular cross section illustrated in Fig. 6 can have a high critical current density. Like the "Advantage 1-3", the n value can be increased.

### Advantage 4

[Structure 4] As illustrated in Fig. 2, the primary assemblies 10 satisfy 1.9 ≤ L/df ≤ 3.2, wherein L denotes a space between a Nb filament 12 of one of the primary assemblies 10 and the nearest Nb filament 12 of adjacent one of the primary assemblies 10 in a cross section of the primary assemblies 10 viewed in an axial direction of the corresponding primary assemblies 10, and df denotes the diameter of the Nb filaments 12 (see Fig. 8).

Like the "Advantage 2-1" and "Advantage 2-2", the Nb filaments 12 of the [Structure 4] can be processed in a good shape. As a result, a Nb₃Sn superconducting wire produced from the precursor 201 having a circular cross section illustrated in Fig. 6 can have a high critical current density. Like the "Advantage 2-3", the n value can be increased.

### Modified Example 1

These embodiments may be modified. In these embodiments, the precursor 1 (see Fig. 1) has a rectangular cross section, and the precursor 201 (see Fig. 6) has a circular cross section. However, the precursor 1 may have a cross section other than the rectangular and circular cross sections (for example, an elliptical cross section).

### Modified Example 2

The precursor 1 and the precursor 201 (hereinafter collectively referred to as a "precursor 1") may include a component and/or a layer not described in the embodiments described above. For example, the precursor 1 may include a reinforcing member. The reinforcing member may be composed of a high-strength material containing Ta and/or Ti. The reinforcing member may be disposed at the center of a cross section of the precursor 1. The reinforcing member may be spread over the superconducting matrix 4.

### Modified Example 3

In the precursor 1, the bronze region 11 has a bronze ratio of 2.5. The same results are obtained when the bronze ratio ranges from 2.0 to 3.0. The bronze ratio preferably ranges from 2.2 to 2.7, more preferably 2.4 to 2.6.

### Modified Example 4

The numerical ranges in the embodiments described above may be appropriately converted. For example, the ds/df or L/df range is specified in the embodiments. These ranges may be converted into the ds/Lc or L/Lc range using the center-to-center distance Lc illustrated in Fig. 2. This conversion is described in detail below. In the embodiments, df was 6.0 µm, and Lc was 51 µm. The upper limit and lower limit of the ds/df or L/df range may be multiplied by 6/51 to convert the ds/df or L/df range into the ds/Lc or L/Lc range. More specifically, for example, "2.1 ≤ L/df ≤ 3.1" of the precursor 1 may be converted into "0.25 ≤ L/Lc ≤ 0.37". For example, "1.9 ≤ L/df ≤ 3.2" of the precursor 201 may be converted into "0.22 ≤ L/Lc ≤ 0.38".

### Modified Example 5

The upper limits and lower limits of these numerical ranges (including "Modified Example 4") may be appropriately combined. For example, "0.10 ≤ ds/df ≤ 0.35" and "2.1 ≤ L/df ≤ 3.1" of the precursor 1 may be partly combined such that "0.10 ≤ ds/df and 2.1 ≤ L/df". For example, "0.08 ≤ ds/df ≤ 0.40" and "1.9 ≤ L/df ≤ 3.2" of the precursor 201 may be partly combined such that "0.08 ≤ ds/df and 1.9 ≤ L/df".

## Claims

1. A precursor for producing Nb₃Sn superconducting wires, the precursor having a rectangular cross section having an aspect ratio of 2.30 or less, comprising:
a plurality of primary assemblies,
wherein the primary assemblies include
a bronze region having a Sn concentration of 15% or more by weight and containing at least one additive of Ti and Zr in an amount of 0.3% to 0.5% by weight, and
a plurality of Nb filaments embedded in the bronze region,
and the primary assemblies satisfy
0.10 ≤ ds/df ≤ 0.35,
wherein ds denotes a space between adjacent Nb filaments aligned in a direction toward a central portion of a cross section of each of the primary assemblies viewed in an axial direction of the corresponding primary assembly, and df denotes the diameter of the Nb filaments.

2. A precursor for producing Nb₃Sn superconducting wires, the precursor having a rectangular cross section having an aspect ratio of 2.30 or less, comprising:
a plurality of primary assemblies,
wherein the primary assemblies include
a bronze region having a Sn concentration of 15% or more by weight and containing at least one additive of Ti and Zr in an amount of 0.3% to 0.5% by weight, and
a plurality of Nb filaments embedded in the bronze region,
and the primary assemblies satisfy
2.1 ≤ L/df ≤ 3.1,
wherein L denotes a space between a Nb filament of one of the primary assemblies and the nearest Nb filament of adjacent one of the primary assemblies in a cross section of the primary assemblies viewed in an axial direction of the corresponding primary assemblies, and df denotes the diameter of the Nb filaments.

3. A precursor having a circular cross section for producing Nb₃Sn superconducting wires, comprising:
a plurality of primary assemblies,
wherein the primary assemblies include
a bronze region having a Sn concentration of 15% or more by weight and containing at least one additive of Ti and Zr in an amount of 0.3% to 0.5% by weight, and
a plurality of Nb filaments embedded in the bronze region,
and the primary assemblies satisfy
0.08 ≤ ds/df ≤ 0.40,
wherein ds denotes a space between adjacent Nb filaments aligned in a direction toward a central portion of a cross section of each of the primary assemblies viewed in an axial direction of the corresponding primary assembly, and df denotes the diameter of the Nb filaments.

4. A precursor having a circular cross section for producing Nb₃Sn superconducting wires, comprising:
a plurality of primary assemblies,
wherein the primary assemblies include
a bronze region having a Sn concentration of 15% or more by weight and containing at least one additive of Ti and Zr in an amount of 0.3% to 0.5% by weight, and
a plurality of Nb filaments embedded in the bronze region,
and the primary assemblies satisfy
1.9 ≤ L/df ≤ 3.2,
wherein L denotes a space between a Nb filament of one of the primary assemblies and the nearest Nb filament of adjacent one of the primary assemblies in a cross section of the primary assemblies viewed in an axial direction of the corresponding primary assemblies, and df denotes the diameter of the Nb filaments.

## Patentansprüche

1. Vorläufer zur Herstellung von Nb₃Sn-Supraleitdrähten, wobei der Vorläufer einen rechteckigen Querschnitt mit einem Seitenverhältnis von 2,30 oder weniger aufweist, umfassend:
eine Vielzahl von Primärbaugruppen,
wobei die Primärbaugruppen
eine Bronzebereich, aufweisend eine Sn-Konzentration von 15 Gewichts% oder mehr und enthaltend mindestens einen Zusatzstoff von Ti und Zr in einer Menge von 0,3 Gewichts% bis 0,5 Gewichts% und
eine Vielzahl von Nb-Filamenten, eingebettet in dem Bronzebereich, einschließen
und die Primärbaugruppen
0,10 ≤ ds/df ≤ 0,35 genügen,
wobei ds einen Raum zwischen benachbarten Nb-Filamenten, ausgerichtet in eine Richtung zu einem Zentralteil eines Querschnitts von jeder der Primärbaugruppen, betrachtet in eine Achsenrichtung der zugehörigen Primärbaugruppe, bezeichnet und df den Durchmesser der Nb-Filamente bezeichnet.

2. Vorläufer zur Herstellung von Nb₃Sn-Supraleitdrähten, wobei der Vorläufer einen rechteckigen Querschnitt mit einem Seitenverhältnis von 2,30 oder weniger aufweist, umfassend:
eine Vielzahl von Primärbaugruppen,
wobei die Primärbaugruppen
eine Bronzebereich, aufweisend eine Sn-Konzentration von 15 Gewichts% oder mehr und enthaltend mindestens einen Zusatzstoff von Ti und Zr in einer Menge von 0,3 Gewichts% bis 0,5 Gewichts% und
eine Vielzahl von Nb-Filamenten, eingebettet in dem Bronzebereich, einschließen
und die Primärbaugruppen
2,1 ≤ L/df ≤ 3,1 genügen,
wobei L einen Raum zwischen einem Nb-Filament von einer der Primärbaugruppen und dem nächstgelegenen Nb-Filament eines benachbarten der Primärbaugruppen in einem Querschnitt der Primärbaugruppen, betrachtet in einer Achsenrichtung der zugehörigen Primärbaugruppen, bezeichnet und df den Durchmesser der Nb-Filamente bezeichnet.

3. Vorläufer, aufweisend einen kreisförmigen Querschnitt, zur Herstellung von Nb₃Sn-Supraleitdrähten, umfassend:
eine Vielzahl von Primärbaugruppen,
wobei die Primärbaugruppen
eine Bronzebereich, aufweisend eine Sn-Konzentration von 15 Gewichts% oder mehr und enthaltend mindestens einen Zusatzstoff von Ti und Zr in einer Menge von 0,3 Gewichts% bis 0,5 Gewichts% und
eine Vielzahl von Nb-Filamenten, eingebettet in dem Bronzebereich, einschließen
und die Primärbaugruppen
0,08 ≤ ds/df ≤ 0,40 genügen,
wobei ds einen Raum zwischen benachbarten Nb-Filamenten, ausgerichtet in eine Richtung zu einem Zentralteil eines Querschnitts von jeder der Primärbaugruppen, betrachtet in eine Achsenrichtung der zugehörigen Primärbaugruppe, bezeichnet und df den Durchmesser der Nb-Filamente bezeichnet.

4. Vorläufer, aufweisend einen kreisförmigen Querschnitt, zur Herstellung von Nb₃Sn-Supraleitdrähten, umfassend:
eine Vielzahl von Primärbaugruppen,
wobei die Primärbaugruppen
eine Bronzebereich, aufweisend eine Sn-Konzentration von 15 Gewichts% oder mehr und enthaltend mindestens einen Zusatzstoff von Ti und Zr in einer Menge von 0,3 Gewichts% bis 0,5 Gewichts% und
eine Vielzahl von Nb-Filamenten, eingebettet in dem Bronzebereich, einschließen
und die Primärbaugruppen
1,9 ≤ L/df ≤ 3,2 genügen,
wobei L einen Raum zwischen einem Nb-Filament von einer der Primärbaugruppen und dem nächstgelegenen Nb-Filament eines benachbarten der Primärbaugruppen in einem Querschnitt der Primärbaugruppen, betrachtet in einer Achsenrichtung der zugehörigen Primärbaugruppen, bezeichnet und df den Durchmesser der Nb-Filamente bezeichnet.

## Revendications

1. Précurseur pour produire des fils supraconducteurs en Nb₃Sn, le précurseur ayant une section transversale rectangulaire ayant un rapport de longueur de 2,30 ou moins, comprenant :
une pluralité d'assemblages primaires,
dans lequel les assemblages primaires incluent
une région en bronze ayant une concentration en Sn de 15 % en poids ou plus et contenant au moins un additif de Ti et Zr en une quantité de 0,3 % à 0,5 % en poids, et
une pluralité de filaments de Nb encastrés dans la région en bronze,
et les assemblages primaires satisfont
0,10 ≤ ds/df ≤ 0,35,
dans lequel ds désigne un espace entre des filaments de Nb adjacents alignés dans une direction vers une portion centrale d'une section transversale de chacun des assemblages primaires visualisés dans une direction axiale de l'assemblage primaire correspondant, et df désigne le diamètre des filaments de Nb.

2. Précurseur pour produire des fils supraconducteurs en Nb₃Sn, le précurseur ayant une section transversale rectangulaire ayant un rapport de longueur de 2,30 ou moins, comprenant :
une pluralité d'assemblages primaires,
dans lequel les assemblages primaires incluent
une région en bronze ayant une concentration en Sn de 15 % en poids ou plus et contenant au moins un additif de Ti et Zr en une quantité de 0,3 % à 0,5 % en poids, et
une pluralité de filaments de Nb encastrés dans la région en bronze,
et les assemblages primaires satisfont
2,10 ≤ L/df ≤ 3,1,
dans lequel L désigne un espace entre un filament de Nb d'un des assemblages primaires et le filament de Nb le plus proche d'un assemblage adjacent des assemblages primaires dans une section transversale des assemblages primaires visualisés dans une direction axiale des assemblages primaires correspondants, et df désigne le diamètre des filaments de Nb.

3. Précurseur ayant une section transversale circulaire pour produire des fils supraconducteurs en Nb₃Sn, comprenant :
une pluralité d'assemblages primaires,
dans lequel les assemblages primaires incluent
une région en bronze ayant une concentration en Sn de 15 % en poids ou plus et contenant au moins un additif de Ti et Zr en une quantité de 0,3 % à 0,5 % en poids, et
une pluralité de filaments de Nb encastrés dans la région en bronze,
et les assemblages primaires satisfont
0,08 ≤ ds/df ≤ 0,40,
dans lequel ds désigne un espace entre des filaments de Nb adjacents alignés dans une direction vers une portion centrale d'une section transversale de chacun des assemblages primaires visualisés dans une direction axiale de l'assemblage primaire correspondant, et df désigne le diamètre des filaments de Nb.

4. Précurseur ayant une section transversale circulaire pour produire des fils supraconducteurs en Nb₃Sn, comprenant :
une pluralité d'assemblages primaires,
dans lequel les assemblages primaires incluent
une région en bronze ayant une concentration en Sn de 15 % en poids ou plus et contenant au moins un additif de Ti et Zr en une quantité de 0,3 % à 0,5 % en poids, et
une pluralité de filaments de Nb encastrés dans la région en bronze,
et les assemblages primaires satisfont
1,9 ≤ L/df ≤ 3,2,
dans lequel L désigne un espace entre un filament de Nb d'un des assemblages primaires et le filament de Nb le plus proche d'un assemblage adjacent des assemblages primaires dans une section transversale des assemblages primaires visualisés dans une direction axiale des assemblages primaires correspondants, et df désigne le diamètre des filaments de Nb.
